(19) Europäisches Patentamt

European Patent Office

Office européen des brevets

(11) **EP 1 624 574 A1**

(12) **EUROPEAN PATENT APPLICATION**

(43) Date of publication:
**08.02.2006 Bulletin 2006/06**

(51) Int Cl.:
*H03L 7/099* *(2006.01)*    *H03L 7/081* *(2006.01)*
*H03L 7/12* *(2006.01)*    *H04B 1/707* *(2006.01)*

(21) Application number: **05107261.9**

(22) Date of filing: **05.08.2005**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(30) Priority: **05.08.2004 DE 102004038100**

(71) Applicant: **TEXAS INSTRUMENTS DEUTSCHLAND GMBH**
**85356 Freising (DE)**

(72) Inventors:
• **Seibold, Hermann**
  **85410 Haag (DE)**
• **Rombach, Gerd**
  **85354 Freising (DE)**

(74) Representative: **Holt, Michael et al**
**Texas Instruments Ltd**
**European Patents Department**
**PO Box 5069**
**Northampton, Northamptonshire NN4 7ZE (GB)**

(54) **Digital spread spectrum clock signal generation**

(57)    To generate a spread frequency spectrum clock signal in a digital approach permitting to make the key parameters independent of process, temperature and supply voltage variations, a digital phase locked loop is used. In a first step (a), a clock signal at a maximum clock frequency (fmax) is generated. In a second step (b), the clock frequency is stepwise reduced by incrementally adding phase delay steps to the clock signal until a minimum clock frequency (fmin) is reached. In a further step (c), the number of incrementally added phase delay steps is stepwise reduced until the maximum clock frequency (fmax) is reached. Steps (a) to (c) are continuously repeated.

FIG. 2

EP 1 624 574 A1

**Description**

FIELD OF THE INVENTION

The present invention relates to a method of generating a digital spread frequency spectrum clock signal, and to a digital spread frequency spectrum clock signal generator.

BACKGROUND OF THE INVENTION

By spreading the frequency of a clock signal over a frequency band compatible with the requirements of a particular environment, e.g., in a range of 0.5 to 1.0% of a system frequency, the electromagnetic interference can be substantially reduced. As is well known, for example from U.S. Patent Nos. 5,867,524 and 5,710,524, an adequate frequency modulation profile is necessary to obtain a flat plateau in the frequency spectrum, thereby permitting the energy peak of a single frequency to be reduced by more than 10dB.

Conventional approaches to generate a clock signal with a spread frequency spectrum use analog techniques. A problem with analog techniques is the dependency on (chip production) process, temperature and supply voltage variations.

BRIEF SUMMARY OF THE INVENTION

The present invention provides a method of generating a spread frequency spectrum clock signal using a digital approach, permitting key parameters to be made independent of process, temperature and supply voltage variations. Specifically, the invention provides a method of digitally generating a spread frequency spectrum clock signal using a phase locked loop.

An embodiment of the method comprises the steps of: a) generating a clock signal at a maximum clock frequency; b) stepwise reducing the clock frequency by incrementally adding phase delay steps to the clock signal until a minimum clock frequency is reached; c) stepwise reducing the number of incrementally added phase delay steps until the maximum clock frequency is reached; and d) repeating steps a) to c).

The invention also provides apparatus in the form of digital spread frequency spectrum clock signal generator.

An embodiment of the apparatus comprises a phase locked loop with a voltage-controlled ring oscillator that has an output and a frequency control input; a phase discriminator with a reference signal input; a feedback signal input; and an output from which a frequency control signal is derived for application to the frequency control input of the ring oscillator. A feedback signal deriving circuit includes a multiplexer with a plurality of inputs each connected to a different one of output taps between successive stages of the ring oscillator and with a pair of outputs, and a phase interpolator with inputs each connected to a different one of the output pair of the multiplexer and an output that feeds a feedback signal to the feedback input of the phase discriminator through an optional frequency divider.

In a preferred implementation, the feedback signal deriving circuit further includes a control circuit that controls the multiplexer and the phase interpolator such that the frequency spectrum of the generated clock signal has a substantially flat plateau. To achieve this, the feedback signal deriving circuit further includes a shift register with outputs connected to control inputs of the multiplexer and to a control input of the phase interpolator. A gate circuit connects the output of the ring oscillator through an optional frequency divider with the input of the shift register. A control logic circuit has an input connected to the output of the ring oscillator and an output connected to a control input of the gate circuit. The pair of outputs of the multiplexer supplies a pair of intermediate phase clock signals with a relative phase shift equal to the smallest phase shift between the output taps of the ring oscillator. The phase interpolator divides the phase difference between the pair of intermediate phase clock signals into a discrete number of intermediate phase values. A control signal received from the shift register at the control input of the phase interpolator selects the phase of the feedback signal at the output of the phase interpolator among the phases of the pair of intermediate phase clock signals and any of the intermediate phase values. As a result, the phase of the feedback signal at the output of the phase interpolator is determined by a bit pattern fed through the shift register and the bit pattern is generated by controlling the gate circuit such that pulses are selectively passed or blocked.

BRIEF DESCRIPTION OF THE DRAWINGS

Embodiments of the invention are described with reference to accompanying drawings, wherein:

FIG. 1 is a graph, plotting the energy of clock signals versus the clock frequency for a spread frequency spectrum as compared to a single clock frequency;

FIG. 2 is a graph that illustrates a frequency selection scheme over time to achieve a flat plateau of the clock

frequency spectrum;

FIG. 3 illustrates a phase step scheme useful in implementing the invention; and

FIG. 4 is a block diagram of an embodiment of a digital spread frequency spectrum clock signal generator utilizing the principles of the invention.

## DETAILED DESCRIPTION OF EMBODIMENTS OF THE INVENTION

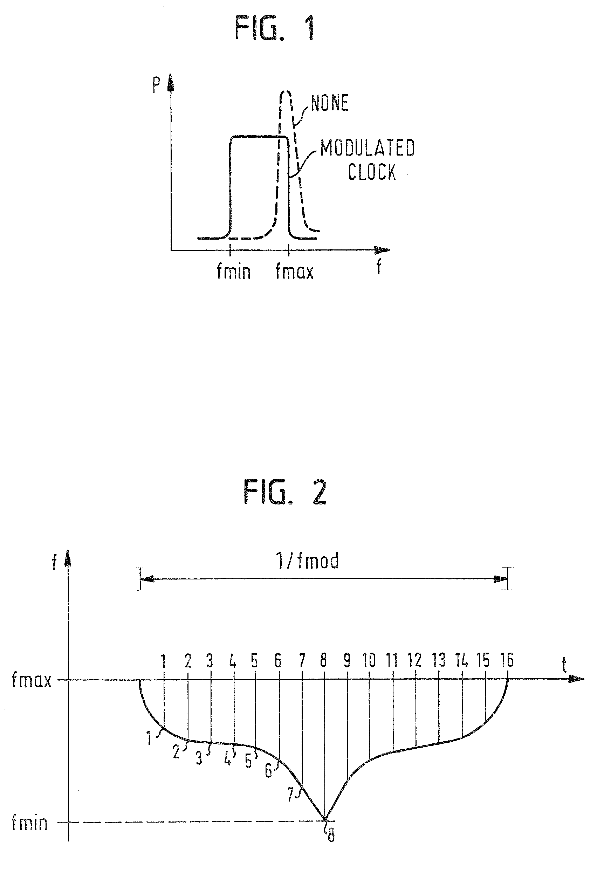

In FIG. 1, wherein the energy P is schematically plotted against the frequency f, the energy distribution of a typical clock signal at a nominal clock frequency fmax is shown by a dotted line. There is a narrow peak centered about frequency fmax. In contrast, as shown by the solid line, a spread frequency spectrum clock signal would extend between a minimum frequency fmin and a maximum frequency fmax, preferably with a flat plateau. A frequency range of about .5 to 1.0 % of the nominal frequency is sufficient to reduce by more than 10 dB the electromagnetic interference caused by the clock signal.

To achieve the flat plateau of the clock energy distribution shown in FIG. 1, a frequency selection scheme such as shown in FIG. 2 can be used. It should be noted that this is a digital implementation where the clock frequency spectrum is composed of digitally generated discrete frequencies. For an illustrated example, the frequency range from fmin to fmax is shown covered by nine discrete frequency values, in 16 time steps. This gives a modulation frequency fmod with a period Tmod which is equal to the sum of the 16 time steps. Starting from fmax, the frequency is reduced stepwise in time steps of Tmod/16, by adding different numbers of incremental phase delay steps of equal amount until fmin is reached after eight cumulated phase delay steps. Thereafter, the number of added phase delay steps is reduced stepwise until fmax is reached again after eight reductions of the added phase delay.

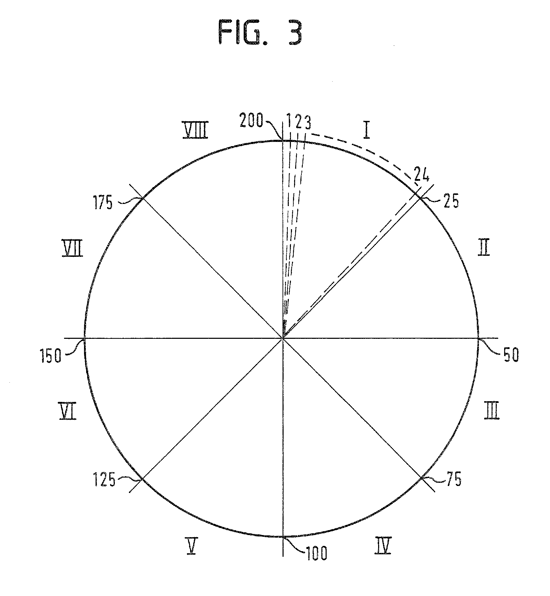

The repeated sequence of stepwise applied incremental phase delays is illustrated by the diagram given in FIG. 3. The clock signal is generated by a voltage-controlled ring oscillator. Each half oscillator period corresponding to one of the logical states, Low and High, is divided in four out of a total of eight sectors I to VIII of a full 360° clock period. Corresponding signals are available at the output taps of the ring oscillator. Starting from the maximum clock frequency fmax at zero phase delay, phase delay steps are incrementally added until the minimum clock frequency fmin is reached. Each phase delay step added in a signal period results in a lower clock frequency. In the example shown, each sector I to VIII is divided into 25 phase steps so that the minimum frequency fmin is reached after 100 cumulated phase delay steps. By subsequently reducing the number of added phase steps, the clock frequency is then stepwise increased to fmax, after a total of 200 phase adjustments.

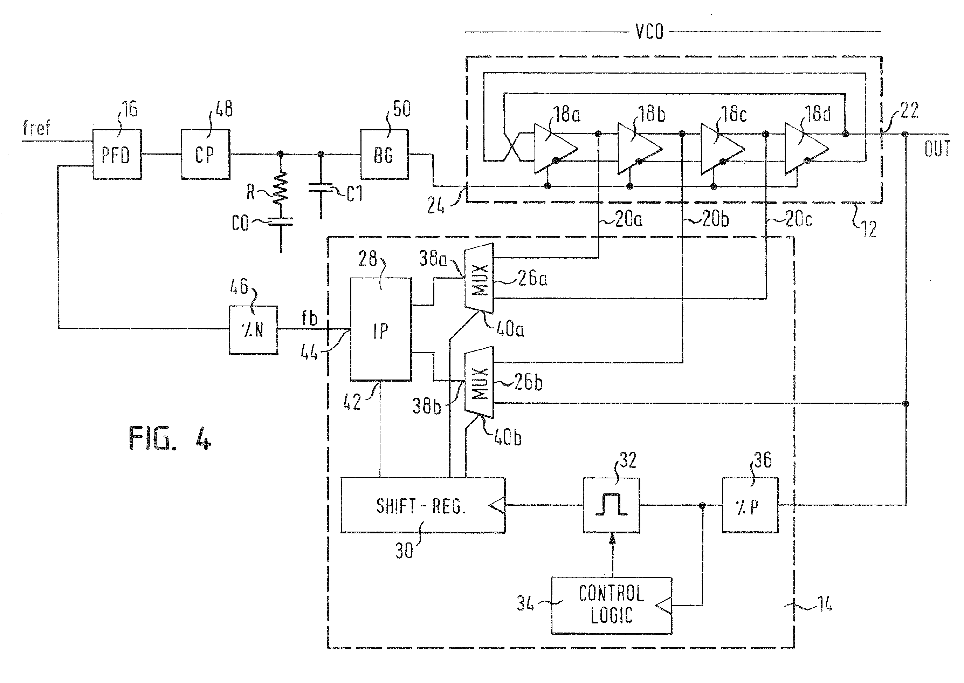

An exemplary implementation of a phase locked loop for a digital spread frequency spectrum clock signal generator is depicted in FIG. 4. It comprises a voltage-controlled ring oscillator 12, a feedback signal deriving circuit 14, and a phase discriminator 16.

The voltage-controlled ring oscillator 12 is implemented in the form of a ring oscillator with four cascaded amplifiers 18a - 18d forming four stages of the ring oscillator. Between successive stages, there are output taps 20a - 20c. The voltage-controlled ring oscillator 12 has an output 22 and a frequency control input 24.

The feedback signal deriving circuit 14 comprises a multiplexer with two stages 26a and 26b, a phase interpolator 28, a shift register 30, a gate circuit 32, a control logic circuit 34 and a frequency divider 36, which divides the frequency by a divisor P. Shift register 30, gate circuit 32, control logic circuit 34 and frequency divider 36 together form a control circuit for controlling multiplexer 26 and phase interpolator 28. Output 22 of voltage-controlled ring oscillator 12 is connected to an input of gate circuit 32 via frequency divider 36. A control input of gate circuit 32 is connected to an output of control logic circuit 34, the control input of which is also connected to the output of frequency divider 36. Thus, control logic circuit 34 controls gate circuit 32. An output of gate circuit 32 is connected to an input of shift register 30. Multiplexer stages 26a and 26b each have two inputs, an output 38a, 38b and a control input 40a, 40b from shift register 30. The inputs of multiplexer stage 26a are respectively connected to output taps 20a, 20c of the voltage-controlled ring oscillator. Amplifiers 18b and 18c are inserted between these output taps. The inputs of multiplexer stage 26b are respectively connected to output tap 20b and to output 22. Amplifiers 18c and 18d are inserted between these output taps. Control inputs 40a, 40b of multiplexer stages 26a, 26b are connected to corresponding outputs of shift register 30, and outputs 38a, 38b of the multiplexer stages are connected to corresponding inputs of the phase interpolator 28. A control input 42 of phase interpolator 28 is connected to a corresponding output of shift register 30.

An output 44 of phase interpolator 28 provides the output of feedback signal deriving circuit 14 and is connected via a frequency divider 46 with a divisor N to a feedback signal input of phase discriminator 16. Another input of phase discriminator 16 is connected to a reference frequency source fref. The loop is closed by connecting an output of phase discriminator 16 via a charge pump 48 and a bias generator 50 to frequency control input 24 of voltage-controlled ring oscillator 12. Compensation circuitry comprises a resistor R and capacitors C0, C1 connected between charge pump 48 and bias generator 50.

In operation, voltage-controlled ring oscillator 12 generates a frequency f which is supplied at output 22. The signals supplied at output taps 20a - 20c are at the same frequency f but each have a different phase. As voltage-controlled ring oscillator 12 has four stages and each signal period is comprised of a low pulse and a high pulse, the phase difference between successive outputs for the illustrated embodiment amounts to 360°/8 = 45°. The signals fed to multiplexer stage 26a have a phase difference of 90 degrees. The signals fed to multiplexer stage 26b also have a phase difference of 90 degrees. The multiplexer stages 26a, 26b are controlled so that the signals supplied at outputs 38a and 38b always have a phase difference of 45 degrees. The signals supplied at the pair of outputs 38a and 38b are fed to phase interpolator 28 which divides the phase difference of 45 degrees into smaller phase steps.

As illustrated in FIG. 3, all eight sectors of the oscillator signal are fed to phase interpolator 28, one after the other. Phase interpolator 28 may be of a type known in the state of the art. In this example, a phase interpolator 28 is chosen that can divide the 45° phase difference into 25 steps. The four stages of voltage-controlled ring oscillator 12 divide each half period of the oscillator signal with frequency f into four parts. Using the equation:

$$N_{ph} \ = \ 2 \ \times \ N_{VCO} \ \times \ N_{IP} \hspace{4cm} (1)$$

where

$N_{ph}$ =     number of phase steps within one oscillator signal period,
$N_{VCO}$ =     number of oscillator stages, and
$N_{IP}$ =     number of interpolator steps,

the number of phase steps is 200 and the size of each phase step obtained is $1/200^{th}$ of the oscillator signal period. In each oscillator signal period the high and the low pulses must pass the ring of the ring oscillator. This is expressed by the factor "2" in equation (1). Adding cumulated phase steps to a signal results in a decrease of its frequency. In the illustrated embodiment of the inventive circuit, phase steps are selectively and cumulatively added under the control of shift register 30, which is in turn controlled by control logic circuit 34. Assuming in a first approach that in the frequency divider the divisor P = 1 and that gate circuit 32 does not block any pulses, then shift register 30 runs with the oscillator frequency f as a clock. In this scenario, one phase step is added to each oscillator period. Therefore, a feedback frequency fb which is supplied at output 44 of phase interpolator 28 is $1/200^{th}$ lower than the oscillator frequency f. When the divisor P is set to a value of 2, shift register 30 is run with a clock frequency which is half the oscillator frequency f and only every second oscillator period a phase step is added. The average feedback frequency fb at output 44 is then $1/400^{th}$ lower than the oscillator frequency f. Feedback frequency fb is determined by the size of each phase step and by the frequency used as clock frequency for shift register 30.

Thus, feedback signal deriving circuit 14 can provide a feedback frequency fb that is maximally the maximum frequency fmax, which is equal the ring oscillator frequency f when no phase steps are added and that is minimally a minimum frequency fmin when a phase step is added to each oscillator period. The difference fmax - fmin, which is called the spread amount, is defined respectively by the size of the phase steps and the number of phase steps into which one oscillator period is divided (see, equation 1). The spread amount can be stored as a digital value in a register. It is derived from the oscillator frequency and, thus, tracks it.

Gate circuit 32 can block clock pulses selectively. Instead of, or in addition to, dividing the clock frequency by frequency divider 36, control logic circuit 34 can be configured to control gate circuit 32 to pass just the number of pulses necessary to obtain a desired discrete frequency, intermediate between fmax and fmin and to block all other pulses. Accumulated output periods are then averaged. With gate circuit 32 blocking and passing pulses, a certain bit pattern is generated and input to shift register 30. This bit pattern is fed to control input 42 of phase interpolator 28. Each time a pulse arrives at phase interpolator 28, one phase step is added to the phase of the feedback signal. The successively added phase steps in the feedback path of the phase locked loop are very small, so that the noise and therefore the output jitter of voltage-controlled ring oscillator 12 are very low.

A modulation profile as shown in FIG. 2 could be built with nine discrete frequency values in 16 time steps. The necessary frequencies can be obtained as explained above by controlling gate circuit 32. Depending on the size of the time steps, a specific number of oscillator periods is averaged for generating the frequencies. An exemplary frequency f of voltage-controlled ring oscillator 12 is 100 MHz. One oscillator period T is then 10 ns. The oscillator frequency is modulated with a modulation frequency which may be set to 31.25 kHz. One modulation period is then 32 μs. Dividing this modulation period in 16 time steps, as necessary for the modulation profile, leads to time steps with a duration of 2 μs. These 2 μs correspond to 200 oscillator cycles. Therefore, each discrete frequency of the modulation profile can be generated by averaging 200 oscillator periods. More generally, the number of oscillator periods available for averaging can be calculated according to equation (2):

$$N_{op} = f_{VCO} / ( N_{ts} \times f_{mod})\qquad\qquad (2)$$

where

$N_{op}$ = number of oscillator periods,
$f_{VCO}$ = oscillator frequency,
$N_{ts}$ = number of time steps, and
$f_{mod}$ = modulation frequency.

The values can be stored in a register. After one time step, the feedback frequency changes to the next frequency value according to a frequency select scheme as represented in FIG. 2. It is possible to use a sigma delta modulator to continuously correct the difference between the actual frequency and the frequency value stored in the register.

The feedback frequency fb which is supplied at output 44 of phase interpolator 28 is divided by frequency divider 46. The divided frequency is then compared in phase discriminator 16 to a reference frequency fref, which is generated in the digital spread frequency spectrum clock signal generator or fed to it. The output of phase discriminator 16 is fed via charge pump 48 to bias generator 50. The signal output from bias generator 50 is input to frequency control input 24 of voltage-controlled ring oscillator 12. Thus the feedback loop is closed. The minimum loop bandwidth must be at least 10 to 20 times the modulation frequency, so that the phase locked loop can follow the frequency change without reshaping the modulation profile. The maximum loop bandwidth should be chosen to smooth out the discrete frequency steps.

Those skilled in the art to which the invention relates will appreciate that various modifications, additions, and/or substitutions can be made to the described embodiments, without departing from the scope of the invention disclosed and claimed herein.

**Claims**

1. A method of digitally generating a spread frequency spectrum clock signal using a phase locked loop, comprising the steps of:

   a) generating a clock signal at a maximum clock frequency;
   b) stepwise reducing the clock frequency by incrementally adding phase delay steps to the clock signal until a minimum clock frequency is reached;
   c) stepwise reducing the number of incrementally added phase delay steps until the maximum clock frequency is reached; and
   d) repeating steps a) to c).

2. The method of claim 1, wherein the maximum and minimum clock frequencies differ by about 0.5 to 1.0 %.

3. A digital spread frequency spectrum clock signal generator, comprising:

   a phase locked loop with a voltage-controlled ring oscillator that has an output and a frequency control input;
   a phase discriminator with a reference signal input, a feedback signal input and an output from which a frequency control signal is derived for application to the frequency control input of the ring oscillator; and
   a feedback signal deriving circuit, connected and configured for receiving a plurality of inputs from respective output taps between successive stages of the ring oscillator, for developing the feedback signal input for the phase discriminator.

4. A digital spread frequency spectrum clock signal generator, comprising:

   a phase locked loop with a voltage-controlled ring oscillator that has an output and a frequency control input;
   a phase discriminator with a reference signal input, a feedback signal input and an output from which a frequency control signal is derived for application to the frequency control input of the ring oscillator; and
   a feedback signal deriving circuit including a multiplexer with a plurality of inputs, each input coupled to a different one of output taps between successive stages of the ring oscillator, and with outputs; and further including a phase interpolator with inputs respectively connected to the outputs of the multiplexer and with an output that feeds a feedback signal to the feedback input of the phase discriminator.

5. The clock signal generator of claim 4, further comprising a frequency divider, the phase interpolator feeding the feedback signal to the feedback input of the phase discriminator via the frequency divider.

6. The clock signal generator of claim 4 or 5, wherein the feedback signal deriving circuit further includes a control circuit controlling the multiplexer and the phase interpolator, such that the frequency spectrum of the generated clock signal has a substantially flat plateau configuration.

7. The clock signal generator of any of claims 4 - 6, wherein the feedback signal deriving circuit further includes a shift register with outputs connected to control inputs of the multiplexer and to a control input of the phase interpolator and with an input; a gate circuit connecting the output of the ring oscillator through an optional frequency divider with the input of the shift register; and a control logic circuit with an input connected to the output of the ring oscillator and an output connected to a control input of said gate circuit.

8. The clock signal generator according to any of claims 4 - 7, wherein the outputs of the multiplexer supply intermediate phase clock signals with a relative phase shift equal to the smallest phase shift between the output taps of the ring oscillator.

9. The clock signal generator of claim 8, wherein the phase interpolator divides the phase difference between the pair of intermediate phase clock signals into a discrete number of intermediate phase values, and a control signal received from the shift register at the control input of the phase interpolator selects the phase of the feedback signal at the output of the phase interpolator among the phases of the intermediate phase clock signals and any of the intermediate phase values.

10. The clock signal generator of claim 9, wherein the phase of the feedback signal at the output of the phase interpolator is determined by a bit pattern fed through the shift register and the bit pattern is generated by controlling the gate circuit such that pulses are selectively passed or blocked.

# FIG. 1

P

NONE

MODULATED
CLOCK

fmin    fmax    f

# FIG. 2

1/fmod

fmax

1  2  3  4  5  6  7  8  9  10 11 12 13 14 15 16    t

1'
2'  3'
4'  5'
6'
7'

fmin

8'

# FIG. 3

FIG. 4

**European Patent Office**

## EUROPEAN SEARCH REPORT

Application Number

EP 05 10 7261

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | US 2002/140513 A1 (MANEATIS JOHN GEORGE) 3 October 2002 (2002-10-03) * paragraphs [0022] - [0035], [0043]; figures 1,1a * | 1-10 | H03L7/099 H03L7/081 H03L7/12 H04B1/707 |
| X | US 2003/058053 A1 (JEON PHIL-JAE ET AL) 27 March 2003 (2003-03-27) * paragraphs [0008] - [0010], [0043] - [0048], [0064] - [0084]; figures 2,4,6,11 * | 1-10 | |
| A | US 5 389 898 A (TAKETOSHI ET AL) 14 February 1995 (1995-02-14) * column 7, line 30 - column 8, line 18; figure 8 * | 7,9,10 | |

| | TECHNICAL FIELDS SEARCHED (Int.Cl.7) |
|---|---|
| | H03L H04B |

The present search report has been drawn up for all claims

| Place of search | Date of completion of the search | Examiner |
|---|---|---|
| Munich | 9 November 2005 | Waters, D |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

 

& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 05 10 7261

This annex lists the patent family members relating to the patent documents cited in the above-mentioned European search report.
The members are as contained in the European Patent Office EDP file on
The European Patent Office is in no way liable for these particulars which are merely given for the purpose of information.

09-11-2005

| Patent document cited in search report | | Publication date | Patent family member(s) | | Publication date |
|---|---|---|---|---|---|
| US 2002140513 | A1 | 03-10-2002 | NONE | | |
| US 2003058053 | A1 | 27-03-2003 | JP 2003124805 A | | 25-04-2003 |
| US 5389898 | A | 14-02-1995 | NONE | | |

For more details about this annex : see Official Journal of the European Patent Office, No. 12/82